(19) **Europäisches Patentamt**
**European Patent Office**
**Office européen des brevets**

(11) **EP 4 560 141 A1**

(12) **EUROPEAN PATENT APPLICATION**

(43) Date of publication:
**28.05.2025 Bulletin 2025/22**

(21) Application number: **24214235.4**

(22) Date of filing: **20.11.2024**

(51) International Patent Classification (IPC):
**F04D 25/16** (2006.01)  **F04D 27/00** (2006.01)
**F04D 29/58** (2006.01)

(52) Cooperative Patent Classification (CPC):
**F04D 25/166; F04D 27/001; F04D 27/004;
F04D 29/582; G06F 1/206; G06F 1/28;
G06F 1/3206; H05K 7/20709; H05K 7/20745;
H05K 7/20836;** F05D 2270/303; F05D 2270/304;
F05D 2270/309

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.11.2023 US 202363601696 P
04.10.2024 US 202418906596**

(71) Applicant: **Vertiv Corporation
Westerville, OH 43082 (US)**

(72) Inventors:
• **CARNEY, Kevin B.
Marengo (US)**
• **MALONEY, Andrew James
Columbus (US)**
• **HEBER, Brian
Ostrander (US)**

(74) Representative: **Beal, James Michael et al
Kilburn & Strode LLP
Lacon London
84 Theobalds Road
London WC1X 8NL (GB)**

(54) **SYSTEMS AND METHODS FOR COOLING FAN CONTROL**

(57)    The present disclosure relates to a system and method for independently controlling, in real time, the speeds of a plurality of fans being used to cool a device, where the device has a sensor block having at least one temperature sensor. The system and method utilizes active learning to help optimize a calculation of a real time fan speed command needed to be applied to at least one fan to cool the device, or a component of the device, which the plurality of fans are associated with.

FIG. 1

**EP 4 560 141 A1**

## Description

CROSS-REFERENCE TO RELATED APPLICATIONS

This application claims the benefit of U.S. Provisional Application No. 63/601,696, filed on November 21, 2023, and U.S. Non-Provisional Application No. 18/906,596, filed on October 4, 2024.

FIELD

The present disclosure relates to systems and methods for controlling cooling fans, and in some applications cooling fans used to cool data center infrastructure and IT devices, using control schemes having an intelligent learning capability which are able to at least one of predict a remaining lifespan of a fan, to adjust a variety of fan operating parameters to optimize an operating lifespan of a fan, to control a speed of one or more fans to optimize power consumption based on real time load requirements, and/or optimize a fan speed based on real time device loads to reduce fan noise, and/or to level out the wear of a plurality of fans in a fan assembly.

BACKGROUND

The statements in this section merely provide background information related to the present disclosure and may not constitute prior art.

Many different environments involve the use of Internet Technology ("IT") devices (e.g., servers, switches, PDUs, etc.) and/or infrastructure devices. Modern day data centers are but one example of such environments. IT devices are often mounted in standardized data center equipment racks, which themselves often include one or more cooling fans or cooling fan assemblies to help move cooling air through the cabinet. Because of the expense of such equipment, it is especially important to ensure that the cooling fans employed in cooling such devices are operating reliably and in an optimum manner. Should a cooling fan, or a cooling fan assembly, fail or begin operating intermittently or at an unacceptably low speed, such an occurrence could create a risk of damage to other equipment (e.g., a server) as an unacceptably high heat build-up occurs because of insufficient cooling airflow.

SUMMARY

The present disclosure relates to a method for independently controlling speeds of a plurality of fans being used to cool a device, wherein the device includes a sensor block having at least one temperature sensor. In one implementation the method may comprise determining an actual real-time ambient temperature rate change of a temperature sensor associated with the sensor block relative to a given fan speed. The method may further include determining a real-time rate of change of a load of the device, determining a desired temperature rate change of the temperature sensor and comparing the actual temperature rate change to the desired temperature rate change and generating a learning component therefrom. The method may further include using the learning component to generate the new fan speed command to be applied to the given fan, the new fan speed command representing a new fan speed which at least one of optimizes power consumption of the given fan while still meeting real-time changing temperature and load requirements of the device being cooled, or reduces a fan noise being produced by the given fan while still meeting real-time changing temperature and load requirements of the device being cooled.

In another aspect the present disclosure relates to a method for independently controlling speeds of a plurality of fans of a fan assembly being used to cool a device, wherein the device includes a sensor block having a plurality of temperature sensors associated with different ones of the plurality of fans. In one implementation the method may comprise determining an actual real-time temperature rate change of a temperature sensor associated with the sensor block relative to a given fan speed, determining a real-time rate of change of a load of the device, and determining a desired temperature rate change of the temperature sensor. The method may further include considering a present wear level of each one of said fans of said plurality of fans, and generating a wear balancing component adapted to wear balance the given one of the plurality of fans against remaining ones of the plurality of fans. The method may further include comparing the actual temperature rate change to the desired temperature rate change and generating a learning component which takes into account the wear balancing component when determining a new fan speed command intended to maintain a desired ambient temperature set point. The method may further include using the learning component to generate the new fan speed command to be applied to the given fan, the new fan speed command representing a new fan speed which optimizes power consumption of the given fan while still meeting real-time changing temperature and load requirements of the device being cooled, while balancing a wear of each one of the fans of the fan assembly to even out fan wear.

In still another aspect the present disclosure relates to a system for independently controlling speeds of a plurality of fans of a fan assembly being used to cool a device under a load, wherein the device includes a sensor block having at least one temperature sensor. In some embodiments the system may comprise an electronic control system, a fan speed sensing subsystem in communication with the electronic control system, and a database including a cumulative fan run time for each fan of the fan assembly and fan operating data including a fan efficiency operating speed band. In some embodiments the system may also include a current sensing and voltage measurement subsystem in communication with the electronic control system and configured to help determine an actual real-time temperature rate change of a temperature sensor associated with the sensor block relative to a given fan speed. In some embodiments the system may further include the electronic control system further being configured to determine and use a real-time rate of change of a load of the device and a desired temperature rate change of the temperature sensor to generate a learning component, to consider the cumulative run time of at least one of the fans, and to use the learning component and the cumulative run time to determine a new fan speed command for the at least one of the fans which enables the at least one fan to maintain a desired ambient temperature set point while optimizing power consumption of the at least one fan, while still meeting real-time changing temperature and load requirements of the device being cooled.

BRIEF DESCRIPTION OF THE DRAWINGS

The drawings described herein are for illustrative purposes only of selected embodiments and not all possible implementations, and are not intended to limit the scope of the present disclosure. In the drawings:

Figure 1 is a high level block diagram of one example of a system in accordance with the present disclosure for controlling a plurality of fans;
Figure 2 is a power vs. expected fan speed curve illustrating how the expected fan speed goes up, somewhat linearly, as the power used to drive the fan increases, up to a maximum point where additional power does not create any further tangible fan speed increase;
Figure 3 is one example of a Fan Speed/Failure Probability Look-Up Table that may be used by the system when predicting a remaining lifespan of a cooling fan, as well as determining when a likelihood of a fan failure is imminent; and

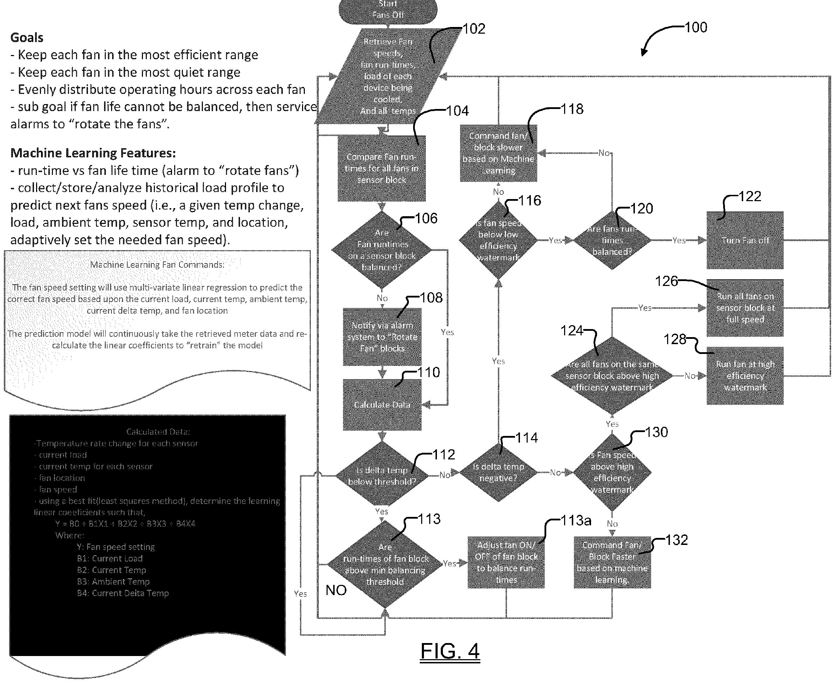

Figure 4 is a flowchart illustrating one high level example of a control scheme for controlling the speeds of multiple fans in an independent fashion, using an active learning methodology, as well as the actual ambient temperature, current load, temperature rate change and current fan speed, for each fan of the system, for the purpose of better determining an actual temperature/load rate change, for each fan of the system, with the goal of generating fan speed control commands which control all of the fans in a most efficient manner, and also in a manner that best balances and evens out wear amongst all the fans.

Corresponding reference numerals indicate corresponding parts throughout the several views of the drawings.

DETAILED DESCRIPTION

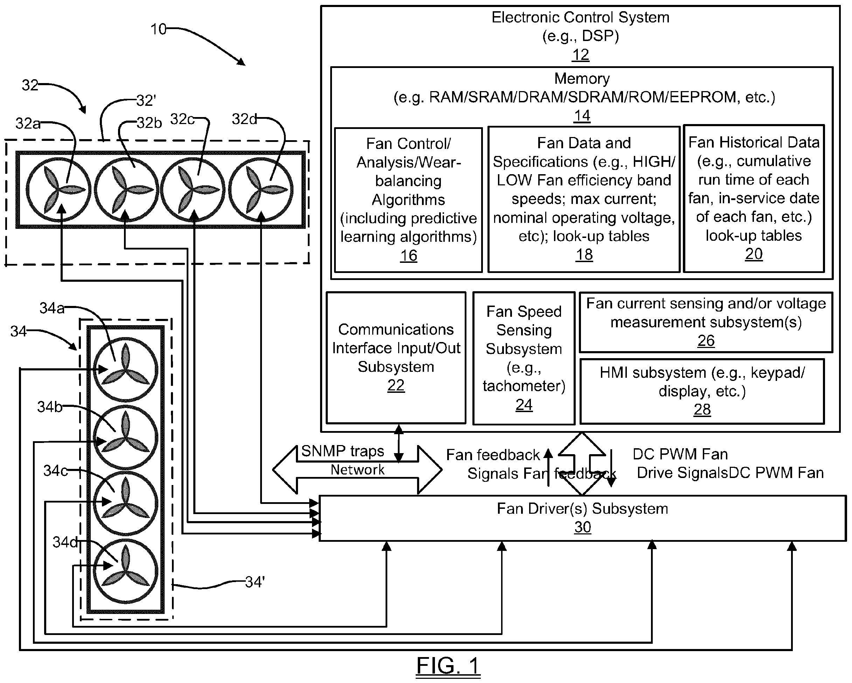

Example embodiments will now be described more fully with reference to the accompanying drawings.
It would be highly beneficial if a system and method could be employed which can not only monitor real time operation of one or more cooling fans, but which could also predict a likely upcoming failure of a cooling fan or cooling fan assembly. This would significantly reduce the risk of damage from excessive heat to other equipment that the cooling fan or fan assembly is being used to cool. It would also be beneficial to data center maintenance personnel by enabling them to schedule a fan replacement before the failure occurs, and thus eliminate the possibility of an emergency condition which arises and significantly disrupts operation of one or more critical IT or infrastructure devices.
It would further be highly beneficial if such a cooling fan control system and method was able to perform a predictive analysis to assess remaining cooling fan or fan assembly life, and to provide some meaningful gauge or indication as to a remaining lifespan of the cooling fan or cooling fan assembly. Such a feature would enable IT personnel to better predict when a cooling fan or cooling fan assembly is approaching its end-of-life.
Still further, it would be highly beneficial if a fan control system and method could be implemented which looks at and analyzes a plurality of important factors such as fan run time, real time ambient temperature conditions, real time load requirements of the IT and infrastructure devices being cooled by the fan control system, etc. It would also be highly beneficial if the fan control system and method could monitor temperature rates of changes being reported by temperature sensors, and is able to determine and implement appropriate fan operating speeds to at least one of optimize fan power consumption or to minimize fan noise, keeping in mind the real time cooling needs of the IT and infrastructure devices. It would also be highly useful if such a system and method could be implemented which also considers one or more of the above factors, while also considering balancing (or "levelling") the run times of a plurality of fans to even out the wear between a group of fans, and thus potentially extend the lifespan of each of the fans.
Referring to Figure 1 there is shown one example of a system 10 in accordance with the present disclosure. The system 10 in this example may include an electronic control system 12 ("ECS 12") having a memory 14 (e.g., RAM/SRAM//DRAM/SDRAM/ROM/EEPROM, etc.). The memory 14 may include both volatile and no-volatile forms of memory, and may form an integral portion of the ECS 12 or optionally may be a stand-alone component that is in bidirectional communication with the ECS 12. The memory 14 may include various modules for storing a wide variety of information needed and/or useful for controlling a fan, and more particularly for independently controlling a plurality of fans. Such modules may include a module 16 for fan control/analysis algorithms (including predictive learning algorithms). Another module 18 may be used storing for fan data including, but not limited to, specifications of all fans being controlled by the system 12 including high and low fan speeds which define a maximum efficiency operating band for each fan, maximum current draw for each fan, nominal operating voltage for each fan, and optionally one or more look-up tables for one or more of the above variables and ranges.

Still another software storage module may include a fan historical operating data module 20 for storing historical data associated with each fan being controlled. Such data may include, for example and without limitation, a cumulative run-time of each fan, an in-service date of each fan, possibly a cumulative run-time that each fan has operated outside of its maximum efficiency operating speed band, and one or more look-up tables related to one or more of the above types of data. Such data may further include a "total run time" defined by a cumulative run-time of each fan at different fan speed percentages (e.g., different percentages of maximum fan speed), and with each cumulative run time weighted based on the fan speed). The weight used, in one example, may also follow an efficiency curve of associated with the fan to provide a more exponential run-time "cost" as the RPM of the fan is increased. Those skilled in this art will appreciate that the foregoing is just a few of the possible types of ways that the fan run-time may be gauged and presented to the user, and the present disclosure is not limited to only these specific examples.

The ECS 12 in one example may be formed by a digital signal processor (DSP). In some embodiments the ECS 12 may take the form of a plurality of independent processors, controllers or control systems for handling designated monitoring and/or computing tasks. The ECS 12 may also include a communications interface I/O (input/output) subsystem 22 (e.g., RS-232; RS422, network protocol, wireless such as BLUETOOTH® protocol) with the appropriate physical connectors (not shown). The ECS 12 communications interface I/O subsystem 22 may be used to send messages (e.g., SNMP (Simple Network Management Protocol) traps) via a local network or a wide area network, or by other communications channels, to other electronic/monitoring subsystems in communication with the control system, or possibly even to a personal electronic device (e.g., smartphone, tablet, laptop, etc.) of a user or IT professional.

A fan speed sensing subsystem 24 (e.g., tachometer or functionally similar speed sensing system) may be included in the ECS 12 as an integral subsystem, or even as a standalone subsystem in communication with the ECS, for monitoring a real-time fan speed for each fan being controlled by the ECS. A fan current sensing and/or voltage measurement ("FCSVM") subsystem 26 may similarly be included with, or as a stand-alone subsystem, for obtaining real-time voltage and/or current measurements associated with the operation of each fan. A human/machine interface ("HMI") subsystem 28 may be included as an integral component of the ECS 12, or alternatively as a stand-alone subsystem, for enabling user programming of the ECS and/or inputting of data or other information by the user, for example fan related operating data (speeds defining a high and low efficiency band for each fan, maximum current and/or voltage inputs, etc.), MAX temperature (i.e., maximum temperature) of a heat sink associated with the fan, etc. The HMI subsystem 30 may include one or more of, or all of, a display (e.g., LCD, touch LCD, LED, etc.), as well as a keypad, as well as one or more specific switches, to enable full or partial control over the ECS 12.

In one implementation the ECS 12 is in communication with a fan driver subsystem 30. The fan driver subsystem 30 contains the drive circuits (e.g., FETs, MOSFETs, etc.) for providing the drive signals (e.g., DC drive signals) to drive one or more fans which the system 12 is controlling. In one implementation the fan drive subsystem 30 may include one or more pulse width modulation (PWM) drive circuits for generating a DC PWM drive signal, having a computer-controlled duty cycle, for each fan being controlled. As such, each fan that the electronic control system 12 controls are able to be fully independently controlled to precisely tailor its speed, in real time, as needed to handle cooling situations in a wide variety of applications and/or to manage cooling of a wide variety of IT or infrastructure devices, equipment cabinets, etc. In some embodiments the fan driver subsystem 30 may form an integral portion of the ECS 12, and in other embodiments the fan driver subsystem 30 may form an independent, fully stand-along subsystem or component that is in bi-directional communication with the ECS. Figure 1 shows the latter implementation, but both implementations are contemplated.

Referring further to Figure 1, the fan driver subsystem 30 is shown in this example being in communication with two independent fan assemblies 32 and 34. Fan assembly 32 is shown with four independently controllable fans 32a-32d and fan assembly 34 is likewise shown having four independently controllable fans 34a-34d. This is but one example, and the ECS 12 and the fan driver subsystem 30 may be scaled to accommodate a greater or lesser number of fan assemblies. Similarly, each fan assembly 32 and 34 may include less than or more than four fans to meet the needs of specific applications.

Figure 1 also shows one specific example of one implementation where fan assembly 32 is disposed closely adjacent to a first heat sink 32', and similarly fan assembly 34 is disposed closely adjacent to another heat sink 34'. Heat sink 32' may include one or more temperature sensors 33 located thereon at one or more predetermined locations on the heat sink. Similarly, heat sink 34' may include one or more temperature sensors 35 located thereon at one or more predetermined locations. Typically, the heat sinks 32' and 34' will have a plurality of temperature sensors 33 and a plurality of temperature sensors 35', respectively, rather than just one each, although both implementations are covered by the present disclosure.

The temperature sensors 33 and 35 provide one or more temperature signals indicating a real-time temperature of different areas of their associated heat sink 32' or 34', which are communicated back to the ECS 12. By "closely adjacent", it is meant, without limitation, typically within a range of a few inches to possibly a few feet. Again, this is but one example, and the fan assemblies 32 and 34 may instead be supported on an equipment cabinet, on or within a cabinet or housing of an IT device or infrastructure device. Those skilled in the art will appreciate that the system 10 is not limited to any specific implementation of fans or any specific number of fans or fan assemblies.

The ECS 12 may monitor and/or control the fan assemblies 32 and 34 to achieve a plurality of different important goals including, but not limited to, predicting remaining useful life of a fan, managing and balancing fan wear between all fans, and controlling fan speed to optimize usage of all the available fans (e.g., in one aspect from a power consumption standpoint), in response to real-time cooling needs. The ECS 12 in some embodiments may also use active learning to further tailor control of one or more fans based on previously observed and/or recorded temperature/fan speed responses and/or cumulative run times of the fans of each fan assembly 32 and 34, and possibly other factors as well.

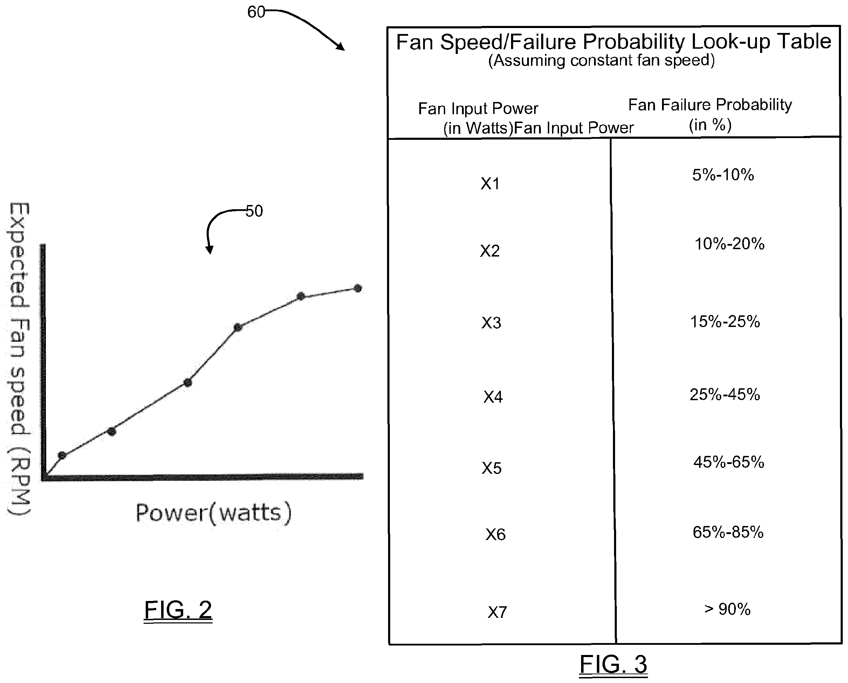

Referring now to Figures 2 and 3, it will be described how monitoring a speed of each fan 32a-32d and 34a-34d may be performed by the system 10 with the goal of monitoring wear of each fan and predicting when a failure of any given fan is likely to occur, before such a failure occurs, as well as predicting a useful remaining life of a fan. This may be accomplished by using the FCSVM subsystem 26 to measure one of current or voltage and/or, in some embodiments, both current and voltage, to determine, in real time, how much input power is being used to drive a given fan of each of the fan assemblies 32 and 34, and also by using the fan speed sensing subsystem 24 to sense the real time fan speed at any given power input. For example, the FCSVM subsystem 26 may involve using a shunt current resistor to monitor a current flow being drawn by the fan, with the understanding that a known nominal voltage is being applied to the fan. Measuring a real-time voltage across a given fan may also be accomplished using well known voltage detection techniques, together with any suitable current sensing approach (e.g., a shunt resistor). When both current draw by the fan and voltage across the fan's input terminals are known, then the power being input (i.e., drawn) by the fan can be easily determined (i.e., P=IxE). The fan manufacturer may in some instances provide specifications as to fan speeds with different input power levels, or this may be empirically determined beforehand through suitable testing.

Empirical testing may also be performed to determine when a given input power is applied, what the resulting expected fan speed should be, and a graph 50 in Figure 2 shows one example to illustrate this. From graph 50, one can see that, for a given power input (in watts), what the expected fan speed should be. The present disclosure uses this known/determined relationship of fan "power-in/expected-fan-speed" to help extrapolate when a fan failure is becoming likely or is imminent. More specifically, the information from graph 50 is used by the system, along with empirical testing and/or manufacturers specifications, to help create data showing a likelihood of fan failure within a further given time period of fan usage (e.g., within the next 100 hours of fan usage). The factor underlying this is that as the lubricant wears down in the fan's motor (e.g., armature bearings) over long term use, more and more friction affecting rotation of the fan's motor can be developed, and it can take more and more power (in watts) to drive the fan at a given rpm. Eventually, one can make a reasonable determination, for example from previous empirical testing, that a fan failure is likely within the next "X" hours of fan operation once a point is reached where it takes "W" watts to drive the fan at a specific speed "S".

Figure 3 shows one high level example of a look-up table 60 that may be created to help define the relationship between likelihood of fan failure and applied power input to a fan. Obviously, a plurality of look-up tables may be created if fans with different operating parameters are being used, so that a specific look-up table is tailored for use with a specific manufacturer/model of fan. From Figure 3, one can see that as the fan power input increases from X1 to X7 (X7 being a maximum power input in watts) to maintain a given fan speed, the probability of a fan failure increases. The system 10 may be programmed to generate an alert to the user, for example an SNMP trap, or possibly to display a warning on an LCD or LED display of the HMI subsystem 28, that failure of a specific fan is imminent or, alternatively, that a fan is nearing an end of its useful life.

An alternative to the use of a look-up table is a suitable algorithm that correlates the power input applied to a fan by, for example: 1) looking at a real time fan speed of a given fan; 2) looking at the power input being applied to drive the fan; and using stored empirical data to calculate what a probability of failure will be within the next "X" hours of fan run-time. In some implementations a suitable algorithm (or algorithms) as just discussed may be used in combination with one or more look-up tables to help make the ultimate determination of a likelihood of fan failure. All of the above-mentioned arrangements are contemplated by the present disclosure. Being able to anticipate a fan failure before the failure occurs is expected to be highly useful for service personnel, as it enables a fan replacement to be scheduled, rather than addressed as an emergency. The ability to predict a fan failure can also help to prevent possible damage to other components being cooled by the fan by allowing service to be scheduled at a convenient time before the failure occurs. Such a convenient time may be, for example, where a subsystem such as a server is idle or experiencing a very low processor utilization, the computing tasks of which can be easily shifted to another server. The ability to predict a fan failure can also help to limit disruptions to the operation of equipment being cooled by the fans.

Referring now to Figure 4, a flowchart 100 is shown of a control methodology for monitoring a plurality of fans to achieve a plurality of goals including, but not necessarily limited to, maintaining operation of each fan within its maximum speed efficiency band in response to temperature rate changes and load rate changes for a device being cooling, while still providing adequate cooling and/or maintaining an ambient temperature setpoint selected by the user. The methodology of flowchart 100 also enables the system to maintain operation of each fan at a calculated speed to minimize fan noise, and/or to evenly distribute operating hours across a plurality of fans contained in a fan assembly (i.e., multiple fans housed within a common housing), and/or indicating when rotation of a fan assembly having multiple fans is recommended to be performed to even out fan wear. In one implementation, the methodology illustrated in Figure 4 is implemented by the ECS 12 of Figure 1. However, it will be appreciated that the methodology illustrated in the flowchart 100 may be implemented by other systems not necessarily identical to the system 10, and the present disclosure is not limited to any particular system hardware design and/or configuration for carrying out the methodology of flowchart 100.

At operation 102, it may be assumed that all of the fans controlled by the system 10 are initially powered off. It can also be assumed, for this example, that the ECS 12 is controlling one fan assembly having multiple fans, for example the fan assembly 32. The ECS 12 may initially retrieve all currently stored data for each fan 32a-32d of the fan assembly 32 being controlled including, but not necessarily limited to, a MAX fan speed (i.e., maximum fan speed) for each fan, the maximum and minimum fan speeds which define a maximum fan efficiency speed band for each fan of the fan assembly, a cumulative run time for each fan of the fan assembly, a load of each device being cooled by the fan assembly 32, all temperatures from the heat sensors 33 and 35 which the ECS can be monitored while controlling the fans of the fan assembly, and the historical set of device load, device temperature, ambient temperature, device delta temperature, and current fan speed.

For the purpose of this example, it is assumed that the fan assembly 32 (Figure 1) is cooling the heat sink 32' of Figure 1, which itself includes the plurality of temperature sensors 33 reporting real-time sensed temperatures to the ECS 12. In this regard it will be appreciated that there can be a known or predetermined relationship or association between each specific temperature sensor 33 and the specific fan of the fan assembly 32 which is associated with the specific temperature sensor, and, in some embodiments, this relationship or association may be recommended. As such, it will be appreciated that each fan of the fan assembly 32 in some instances can be associated with a specific one of the temperature sensors 33 (and similarly for the fans of fan assembly 34 and sensors 35). In some instances, two or more fans may be associated with a specific temperature sensor 33 or 35. In some instances, two or more temperature sensors 33 or 35 may be associated with a single fan of the fan assembly 32. And it will be appreciated that the present disclosure is not limited to any one of the above relationship scenarios and may be configured to operate with virtually any type of sensor/fan relationship to meet the needs of specific applications.

At operation 104, the ECS 12 may obtain from the memory 14 the cumulative fan run times for each of fans 32a-32d of fan assembly 32 and may compare them to one another. At operation 106, from this comparison the ECS 12 can determine if the cumulative run times are balanced. By "balanced" it is meant that the cumulative run times of each of the fans 32a-32d, for a given sensor block (i.e., collectively sensors 33 or 35), are within a predetermined percentage of one another (e.g., within at least 2-10%, or possibly within about 5%, or possibly within a value which is even less than 5%). If the check at operation 106 indicates that the cumulative run times are not balanced, then the ECS 12 may provide an alert to the user to "Rotate Fan Assembly", as indicated at operation 108. By "Rotate Fan Assembly" it is meant to physically rotate the entire fan assembly 32 180 degrees and remount it to its support structure. This is because, typically, the outermost fans 32a and 32d are far more likely to have uneven cumulative run times, relative to each other. The reason for this is often because of the way air flows through a unit being cooled by the fan assembly 32 and/or because the amount of heat which the thermal devices connected to the heat sink are sharing is not equal.

The alert generated by the ECS 12 in one example may be a SNMP trap message sent out to a user or other subsystem over a LAN or wide area network (WAN). Optionally, the alert may be provided to a user via a display of the HMI subsystem 28. These are but a few examples as to how the alert may be provided to a user, and the present disclosure is not limited to any particular scheme or method for providing the alert.

Upon completion of operation 108, at operation 110 the ECS 12 may perform one or more calculations using one or more stored algorithms to implement machine learning fan commands. More specifically, operation 110 may involve a plurality of sub-operations including, but not necessarily limited to, 1) calculating a real time temperature rate change for each sensor 33 of the sensor block associated with the heat sink 32'; 2) calculating a load rate of change for the device being cooled by the fan assembly 32; 3) associating the monitored temperature rate of change, the monitored load rate of change and a real time measured ambient temperature change, to a specific fan speed change, fan orientation/position, and actual temperature change result; and 4) associating the fan speed change, the fan orientation/position and the temperature rate of change to a run-time change balancing component that takes into account the run times of the other fans of the fan assembly 32.

In some embodiments the sub-operations are defined to create the learning model. The learning model uses multi-variable linear regression in the equation of:

Define $y = b_0 + b_1x_1 + b_2x_2$, where y is the dependent variable and $X = [x_1, x_2]$ are the independent variables. Assume $x_1$ and $x_2$ are not dependent on each other or have very little correlation to each other. Then Y is linear with respect to X.

Assume X is an N x m matrix, for this example m = 2, (i.e., only two independent variables) and N is the number of (X,y) data points. In matrix form:

$y = M\hat{X} + B$, where $\hat{X}$ is an N x (m+1) matrix where the first column is all ones. Note $M = [b_1, b_2]'$, and $B = b_0$.

$\hat{X} = [\text{Column of 1's X}]$, the first column all ones with the same number of rows in X. The last two columns are $x_1$ and $x_2$. M and B are found by the following equation.

$$\begin{bmatrix} B \\ M \end{bmatrix} = (X' \cdot X)^{-1} \cdot X'y$$

Example ▪

▪

$$x = \begin{bmatrix} 50 & 1 \\ 50 & -10 \\ 100 & -10 \\ 75 & -10 \\ 75 & 0 \\ 75 & -1 \\ 50 & -1 \\ 100 & 50 \\ 50 & 5 \\ 72 & 1 \\ 50 & -5 \\ 75 & -15 \\ 50 & 0 \\ 50 & -3 \\ 75 & -3 \\ 50 & -1 \end{bmatrix} \quad y = \begin{bmatrix} 15 \\ 75 \\ 100 \\ 100 \\ 25 \\ 30 \\ 20 \\ 0 \\ 5 \\ 20 \\ 50 \\ 100 \\ 20 \\ 20 \\ 50 \\ 25 \end{bmatrix} \quad X = \begin{bmatrix} 1 & 50 & 1 \\ 1 & 50 & -10 \\ 1 & 100 & -10 \\ 1 & 75 & -10 \\ 1 & 75 & 0 \\ 1 & 75 & -1 \\ 1 & 50 & -1 \\ 1 & 100 & 50 \\ 1 & 50 & 5 \\ 1 & 72 & 1 \\ 1 & 50 & -5 \\ 1 & 75 & -15 \\ 1 & 50 & 0 \\ 1 & 50 & -3 \\ 1 & 75 & -3 \\ 1 & 50 & -1 \end{bmatrix}$$

▪

▪

$$\begin{bmatrix} B \\ M \end{bmatrix} = \begin{bmatrix} -35.8507 \\ 1.1696 \\ -2.0002 \end{bmatrix}$$

This can be expanded to any number of independent variables.

The prediction model is configured to output the desired fan speed to achieve that desired temperature using the other above-mentioned factors.

In some embodiments the learned coefficients are calculated as follows:

Least Squares Linear Curve Fit Method

*Single Variable*

Given a data set (X,Y) with n samples, X = [x1, x2 ... xn] and Y = [y1, y2 ... yn], where X is the independent variable and Y is the dependent, there is a function f(x) that can be found that "fits" the data set. The Least Squares approach minimizes the summation of the square of the error as follows:

$$e = \sum_{i=1}^{n} (y_i - f(x_i))^2$$

For the linear case, f(x) = m · x + b, where m is the slope and b is the y-intercept. It is assumed that the data set can be fit adequately to the linear equation. The following are the steps to calculate the best least squares fit.

1. Compute Equation 1:

$$\sum_{i=1}^{n} (y_i) = n \cdot b + m \cdot \sum_{i=1}^{n} (x_i)$$

2. Compute Equation 2:

$$\sum X \cdot f(x), \sum_{i=1}^{n} (x_i \cdot y_i) = b \cdot \sum_{i=1}^{n} (x_i) + m \cdot \sum_{i=1}^{n} (x_i^2)$$

3. Solve for m and b.
4. Calculate the error as given above using (m, b) from step 3.

*Multiple Variable*

For the multi-variable case, it is assumed that X is still the independent variable and Y is the dependent variable, but now, Y is an array of data samples as shown below:

$$Y = \begin{bmatrix} y_{i,1} & \cdots & y_{i,p} \\ \vdots & \ddots & \vdots \\ y_{n,1} & \cdots & y_{n,p} \end{bmatrix}$$

Y is now an "n" x "p" matrix and X is still an "n" x 1 vector. It is further assumed that each Y vector is not dependent on the any other Y vector. Each Y vector is strictly dependent on X.

The Least Squares Linear Fit for the multi-variable case requires that steps 1 through 4 are repeated for each Y column resulting in a linear equation for each Y column. The linear equation can be expressed as: F(x) = M · x + B, where F(x) is now a vector of linear equations, M is a vector of slopes and B is a vector of y-intercepts.

In one example the "balancing" component is actually a secondary component (or consideration or objective) of the learning adjustment. The learning part creates the coefficients of the above equation. Those are obtained by taking all the modeled data mentioned above and generating the best coefficients. The primary component (e.g., objective) is to run the fans as efficiently as possible while learning the correct fan speed adjustments to reach a desired temperature rate change given a current load rate change. The secondary component (e.g., objective) is to slow the fans, or even to turn off the fan(s) to balance total run-times.

So, from the above, it will be appreciated that the fan commands are fan speed adjustments (or possibly in some instances ON/OFF commands) that use the association of a given temperature rate of change and load rate of change to a given fan speed and fan position, with additional input from operation 106 to balance fan run-times. These associations of temperature/load observed over time may then be used to create a "learning" component, which may form a control variable which is used in a suitable machine learning algorithm, which is continuously updated in real time, as the fans 32a-32d accumulate more and more run time. In one example the learning component is obtained through the process of taking the association above (temperature/load rate of change to fan speed/position) that resulted from a previous fan speed command.

From the above, it will be understood that the method "learns" that a given adjustment in fan speed (based upon the current load/temperature and the desired rate of change adjustment or balancing adjustment) needs to be increased or decreased. The learning component can be used to help attempt to even better balance the run times of the fans 32a-32d by more intelligently calculating a speed control adjustment to each fan. The learned speed control adjustments may thus more accurately control the speed of each fan for a given temperature/load rate of change to fan speed/position scenario, taking into account actual observed temperature/load rate response changes in response to past fan speed adjustment commands, as well as also simultaneously balancing the fan run times to the maximum, and further taking into account the historical set of device load, device temperature, ambient temperature, device delta temperature, and current fan speed extent possible. Also, if the check at operation 106 verifies that the cumulative run times of the fans 32a-32d are balanced, then operation 108 may be skipped and operation 110 performed immediately after operation 106.

Referring further to Figure 4, at operation 112, a check can be made if a delta temperature for each sensor of the sensor block (e.g., each one of the group of sensors 33, where the "group" may be viewed as a "block" of sensors) is below a predetermined threshold. In a very broad sense, the ECS 12 here at operation 112 is determining if the delta temperature being reported by a specific temperature sensor 33 of the sensor block is below the predetermined threshold. If the delta temperature is below the predetermined threshold level, then it will be understood that no appreciable rate of change of the temperature is occurring, and that no further action needs to be taken. In this event a check is then made at operation 113 to determine if the total of run times of all fans in a given fan assembly are above a predetermined minimum balancing threshold for making a balanced decision. This preset minimum threshold may be a preset value below that which may require immediate rotation of the fan assembly 32, but which still can indicate that there is room for adjustment of the on/off operation of one or more fans to bring the overall run times of the fans more closely into perfect balance.

So, if the check at operation 113 produces a "YES" answer, then an on/off adjustment can be made to one or more fans at operation 113a, in an attempt to even more perfectly balance the run times of all of the fans of the fan assembly 32, before returning to repeat operations 102-112. A "NO" answer at operation 113 means that the run times of the all the fans in the fan assembly 32 are sufficiently close (e.g., only a negligible difference exists between all the fans of the fan assembly 32), and that no adjustment is needed at the present time to any one or more of the fans. Put differently, any adjustment may make only a trivial difference in further balancing the run times of all of the fans, and as such no adjustment is to be made at this time.

Referring further to Figure 4, if the check at operation 112 determines that the real time temperature rate of change is not below the predetermined threshold, then a check is made at operation 114 if the delta temperature is negative. If the determination at operation 114 produces a "NO" answer, meaning that the delta temperature is positive, then at operation 130 a check is made if the fan(s) associated with that specific sensor 33 is/are presently above the upper speed limit of the maximum efficiency speed band of the fan(s). If this check produces a "NO" answer, then a fan speed increase is permissible. This may involve the ECS 12 issuing a command to the fan assembly 32 to increase the speed of one of the fan(s) under consideration in accordance with the previously determined machine learning calculations performed at operation 110. More broadly speaking, this command seeks to increase the speed of one or more fans of the fan assembly 32 to address the rapidly changing temperature/load condition, while also taking care to balance, as best as possible, the run time of the fan(s) under consideration relative to the other fans of the fan assembly 32. After operation 132, operations 102-112 may be re-performed.

If the check at operation 114 indicates that the delta temperature is negative (and above the predetermined threshold), this indicates that over-cooling is occurring. That is, the rate of change of temperature of the sensor of the sensor block being monitored is falling at an unacceptably high rate. In this situation, a check is made at operation 116 if the speed of the fan (or fans) associated with the temperature sensor under consideration is/are below the low efficiency speed value of the maximum fan speed efficiency range for the specific fan(s) under consideration. If this check produces a "NO" answer, then the fan(s) under consideration need(s) to be slowed down. This is accomplished at operation 118 by having the ECS 12 generate a command, based on its machine learning calculations performed at operation 110, to run the fan(s) under consideration, or possibly all the fans of the fan assembly 32, at a slower speed. Subsequent to operation 118, operations 102-112 may be repeated.

If the check at operation 116 produces a "YES" answer, meaning that the given fan under consideration is already operating below the speed which defines the lower limit of its efficiency speed band, then a check may be made at operation 120 if all the fans of the fan assembly 32 are presently run-time balanced. If this check produces a "NO" answer, meaning that the cooling provided by the fan assembly 32 can be at least somewhat further reduced by commanding lower fan speeds from other ones of the fans of the fan assembly, then operation 118 is performed. Operation 118 determines speed commands for one or more of the other fans of the fan assembly 32 that can be used to reduce the overall cooling output of the fan assembly 32 while simultaneously selecting fan speeds which help to accomplish run-time balancing of all of the fans 32a-32d of the fan assembly. However, if the check at operation 120 indicates that all of the fans of the fan assembly 32 are already run-time balanced (as defined by the lower threshold at operation 113), then at operation 122 only the specific fan under consideration is turned off. In this instance the preference is to prevent or limit over-cooling, even if this means introducing some run-time imbalance to the fans of the fan assembly. Operations 102-112 may then be repeated.

Referring further to the check at operation 130, as noted above, if this operation is reached, it means that the temperature rate of change of the sensor under consideration is positive, meaning that the reported temperature from the temperature sensor is increasing at an unacceptably high rate (i.e., above the predetermined threshold level). And if the check at operation 130 produces a "YES" answer, meaning that the specific fan being considered is presently running above the upper limit of its speed efficiency band, then a check is made at operation 124 to determine if all the other fans of the same sensor block (i.e., all the fans 32a-32d in this example) are above the upper speed limits of their respective maximum efficiency speed bands. If the check at operation 124 produces a "YES" answer, then at operation 126, all fans associated with the given sensor block (i.e., all fans 32a-32d) are commanded to run at maximum speed in an attempt to provide sufficient cooling to halt, mitigate or reverse the temperature rate of change of the sensor block in question. Operations 102-112 may then be repeated. However, if the check at operation 124 produces a "NO" answer, meaning that one or more of the fans of the fan assembly 32 is/are running below the upper limit of its/their maximum speed efficiency band, then those one or more fans may be commanded to run at a speed in accordance with the upper speed limit of its/their maximum efficiency speed band. Operations 102-112 may then be repeated.

Thus, the system 10 can provide an intelligent, active learning system that continuously adjusts the commands being supplied to the fans to maintain, as much as possible, each fan running fan within its maximum efficiency speed band, while still meeting the cooling needs of the device being cooled, and also while adjusting the speeds of all of the fans 32a-32d of the fan assembly 32 to help wear-balance all of the fans. The system 10 and method of the present application assembly 34 can effectively better "learn" over time how to even more efficiently and effectively control fan speeds. The system 10 can do this by continuously reviewing calculated temperature/load rate changes relative to specific fan speeds and specific ambient temperatures, versus actual observed temperature/load rate changes. The system 10 can do this over time at specific fan speeds. Accordingly, the system 10 and method can possibly remediate the effects of external factors associated with the temperature sensors, the ambient environment, or even the fans themselves, that can cause a real world system response to deviate unacceptably from a calculated response.

The system and method of the present disclosure also can help to better optimize fan operation which can lead to reduced power consumption by each fan. Another benefit of the system 10 and above-described methodology of flowchart 100 can be the reduction of fan wear-and-tear by shifting additional needed cooling capacity to fans which are either more lightly loaded, or which have a lower cumulative run-time, wherever possible, while still maintaining proper cooling for each sensor of a sensor block being cooled by a fan assembly. The system 10 and methodology described herein can also provide the benefit in some instances of running the fans at slower speeds which reduce fan noise levels, while still providing the needed cooling for components or devices being cooling.

Lastly, the system and method of the present disclosure is able to determine when wear balancing of the fans of a given fan assembly by controlling run-times is not otherwise possible and may further be able to provide an alert to a user when it is necessary to flip a fan assembly 180 degrees to help balance the wear of specific fans of a given fan assembly. The system and method may generate other alerts associated with the wear of the fans (e.g., approaching end of life, etc.). This further enables the system and method of the present disclosure to help extend the useful life of each one of the fans of a given fan assembly.

The foregoing description of the various embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

Example embodiments are provided so that this disclosure will be thorough, and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms and that neither should be construed to limit the scope of the disclosure. In some example embodiments, well-known processes, well-known device structures, and well-known technologies are not described in detail.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (e.g., "between" versus "directly between," "adjacent" versus "directly adjacent," etc.). As used herein, the term "and/or" includes any and all combinations of one or more of the associated listed items.

Although the terms first, second, third, etc. may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath," "below," "lower," "above," "upper," and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The disclosure comprises the following items:

1. A method for independently controlling speeds of a plurality of fans being used to cool a device, wherein the device includes a sensor block having at least one temperature sensor, the method comprising:

determining an actual real-time ambient temperature rate change of a temperature sensor associated with the sensor block relative to a given fan speed;
determining a real-time rate of change of a load of the device;
determining a desired temperature rate change of the temperature sensor;
comparing the actual temperature rate change to the desired temperature rate change and generating a learning component therefrom; and
using the learning component to generate the new fan speed command to be applied to the given fan, the new fan speed command representing a new fan speed which at least one of:

optimizes power consumption of the given fan while still meeting real-time changing temperature and load requirements of the device being cooled, or
reduces a fan noise being produced by the given fan while still meeting real-time changing temperature and load requirements of the device being cooled.

2. The method of item 1, further comprising considering a present wear level of each one of said fans of said plurality of fans, and generating a wear balancing component adapted to wear balance the given one of the plurality of fans against remaining ones of the plurality of fans.

3. The method of item 1 or item 2, further comprising comparing the actual temperature rate change to the desired temperature rate change and generating a learning component which takes into account the wear balancing component when determining a new fan speed command intended to maintain a desired ambient temperature set point.

4. The method of any preceding item, wherein the new fan speed wear balances the given fan in relation to other ones of the plurality of fans, while still meeting real-time changing temperature and load requirements of the device being cooled.

5. The method of any preceding item, further comprising turning off at least one fan of the fan assembly to help wear balance the given fan.

6. The method of any preceding item, further comprising providing a recommendation to rotate the fan assembly to help wear balance the given fan.

7. The method of any preceding item, wherein the new fan speed is determined in part by determining a present, cumulative run time for each fan of the fan assembly.

8. The method of any preceding item, wherein generating a learning component further includes associating the monitored temperature rate of change, the monitored load rate of change and the real time ambient temperature change to at least one of: a specific fan speed change, a specific fan orientation/position, and an actual temperature change result.

9. The method of any preceding item, wherein the generating a learning component further considers a maximum efficiency speed band of the given fan, and attempts to maintain the fan given operating within the maximum efficiency speed band while meeting a cooling need of the device being cooled.

10. The method of any preceding item, wherein generating a learning component further comprises considering an historical set of device load, device temperature, ambient temperature, change in device temperature, and current fan speed.

11. The method of any preceding item, further comprising:

   monitoring at least one of a current, a voltage or a power being delivered to the given fan;
   monitoring a speed of the given fan; and
   using stored, empirical data to determine a probability of failure of the given fan within a predetermined number of hours of run-time of the given fan.

12. A method for independently controlling speeds of a plurality of fans of a fan assembly being used to cool a device, wherein the device includes a sensor block having a plurality of temperature sensors associated with different ones of the plurality of fans, the method comprising:

   determining an actual real-time temperature rate change of a temperature sensor associated with the sensor block relative to a given fan speed;
   determining a real-time rate of change of a load of the device;
   determining a desired temperature rate change of the temperature sensor;
   considering a present wear level of each one of said fans of said plurality of fans, and generating a wear balancing component adapted to wear balance the given one of the plurality of fans against remaining ones of the plurality of fans;
   comparing the actual temperature rate change to the desired temperature rate change and generating a learning component which takes into account the wear balancing component when determining a new fan speed command intended to maintain a desired ambient temperature set point; and
   using the learning component to generate the new fan speed command to be applied to the given fan, the new fan speed command representing a new fan speed which optimizes power consumption of the given fan while still meeting real-time changing temperature and load requirements of the device being cooled, while balancing a wear of each one of the fans of the fan assembly to even out fan wear.

13. The method of item 12, wherein using the learning component to generate a new fan speed further comprises generating the new fan speed to meet real-time changing temperature and load requirements of the device being cooled.

14. The method of item 12 or item 13, wherein using the learning component to generate a new fan speed includes attempting to reduce fan noise being produced by the given fan while still meeting real-time changing temperature and load requirements of the device being cooled.

15. The method of any of items 12-14, wherein using the learning component to generate a new fan speed includes using the learning component to determine if one or more fans of the fan assembly can be turned off while operating of a remaining plurality of the fans of the fan assembly continue to meet real time changing temperature and load requirements of the device being cooled.

16. The method of any of items 12-15, further comprising:

   monitoring an input power provided to each fan of the fan assembly;
   making a determination of a likelihood of fan failure of each one of said fans based upon a required input power needed to drive each said fan at a given fan speed; and
   providing a notification to a user of a likelihood of fan failure of at least one of the fans based upon the input power presently needed to drive the at least one fan.

17. The method of any of items 12-16, wherein the making a determination of a likelihood of fan failure includes using at least one of:

   an algorithm making use of known fan failure probability data; or
   a look-up table making use of the known fan probability data.

18. A system for independently controlling speeds of a plurality of fans of a fan assembly being used to cool a device under a load, wherein the device includes a sensor block having at least one temperature sensor, the system comprising:

> an electronic control system;
> a fan speed sensing subsystem in communication with the electronic control system;
> a database including a cumulative fan run time for each fan of the fan assembly and fan operating data including a fan efficiency operating speed band;
> a current sensing and voltage measurement subsystem in communication with the electronic control system and configured to help determine an actual real-time temperature rate change of a temperature sensor associated with the sensor block relative to a given fan speed;
> the electronic control system further being configured to:
>
>> determine and use a real-time rate of change of a load of the device and a desired temperature rate change of the temperature sensor to generate a learning component;
>> consider the cumulative run time of at least one of the fans; and
>> use the learning component and the cumulative run time to determine a new fan speed command for the at least one of the fans which enables the at least one fan to maintain a desired ambient temperature set point while optimizing power consumption of the at least one fan, while still meeting real-time changing temperature and load requirements of the device being cooled.

19. The system of item 18, wherein the electronic controller is further configured to consider a cumulative run time of each said fan of the fan assembly, and determines the new fan speed in a manner that wear balances the given fan against other ones of the fans of the fan assembly.

20. The system of item 18 or item 19, wherein the database further includes at least one of:

> a wear balancing algorithm;
> fan data specifications including maximum fan speed, minimum fan speed, a maximum fan current, a nominal operating voltage, and a fan efficiency speed band; and
> fan historical data relating input power required to drive each said fan and associating the input power to a fan failure probability.

**Claims**

1. A method for independently controlling speeds of a plurality of fans being used to cool a device, wherein the device includes a sensor block having at least one temperature sensor, the method comprising:

> determining an actual real-time ambient temperature rate change of a temperature sensor associated with the sensor block relative to a given fan speed;
> determining a real-time rate of change of a load of the device;
> determining a desired temperature rate change of the temperature sensor;
> comparing the actual temperature rate change to the desired temperature rate change and generating a learning component therefrom; and
> using the learning component to generate the new fan speed command to be applied to the given fan, the new fan speed command representing a new fan speed which at least one of:
>
>> optimizes power consumption of the given fan while still meeting real-time changing temperature and load requirements of the device being cooled, or
>> reduces a fan noise being produced by the given fan while still meeting real-time changing temperature and load requirements of the device being cooled.

2. The method of claim 1, further comprising considering a present wear level of each one of said fans of said plurality of fans, and generating a wear balancing component adapted to wear balance the given one of the plurality of fans against remaining ones of the plurality of fans.

3. The method of claim 2, further comprising comparing the actual temperature rate change to the desired temperature rate change and generating a learning component which takes into account the wear balancing component when determining a new fan speed command intended to maintain a desired ambient temperature set point.

4. The method of any preceding claim, wherein the new fan speed wear balances the given fan in relation to other ones of the plurality of fans, while still meeting real-time changing temperature and load requirements of the device being cooled.

5. The method of any preceding claim, further comprising turning off at least one fan of the fan assembly to help wear balance the given fan.

6. The method of any preceding claim, further comprising providing a recommendation to rotate the fan assembly to help wear balance the given fan.

7. The method of any preceding claim, wherein the new fan speed is determined in part by determining a present, cumulative run time for each fan of the fan assembly.

8. The method of any preceding claim, wherein generating a learning component further includes associating the monitored temperature rate of change, the monitored load rate of change and the real time ambient temperature change to at least one of: a specific fan speed change, a specific fan orientation/position, and an actual temperature change result.

9. The method of any preceding claim, wherein the generating a learning component further considers a maximum efficiency speed band of the given fan, and attempts to maintain the fan given operating within the maximum efficiency speed band while meeting a cooling need of the device being cooled.

10. The method of any preceding claim, wherein generating a learning component further comprises considering an historical set of device load, device temperature, ambient temperature, change in device temperature, and current fan speed.

11. The method of any preceding claim, further comprising:

monitoring at least one of a current, a voltage or a power being delivered to the given fan;
monitoring a speed of the given fan; and
using stored, empirical data to determine a probability of failure of the given fan within a predetermined number of hours of run-time of the given fan.

12. A system for independently controlling speeds of a plurality of fans of a fan assembly being used to cool a device under a load, wherein the device includes a sensor block having at least one temperature sensor, the system comprising:

an electronic control system;
a fan speed sensing subsystem in communication with the electronic control system;
a database including a cumulative fan run time for each fan of the fan assembly and fan operating data including a fan efficiency operating speed band;
a current sensing and voltage measurement subsystem in communication with the electronic control system and configured to help determine an actual real-time temperature rate change of a temperature sensor associated with the sensor block relative to a given fan speed;
the electronic control system further being configured to:

determine and use a real-time rate of change of a load of the device and a desired temperature rate change of the temperature sensor to generate a learning component;
consider the cumulative run time of at least one of the fans; and
use the learning component and the cumulative run time to determine a new fan speed command for the at least one of the fans which enables the at least one fan to maintain a desired ambient temperature set point while optimizing power consumption of the at least one fan, while still meeting real-time changing temperature and load requirements of the device being cooled.

13. The system of claim 12, wherein the electronic controller is further configured to consider a cumulative run time of each said fan of the fan assembly, and determines the new fan speed in a manner that wear balances the given fan against other ones of the fans of the fan assembly.

14. The system of claim 12 or claim 13, wherein the database further includes at least one of:

a wear balancing algorithm;
fan data specifications including maximum fan speed, minimum fan speed, a maximum fan current, a nominal operating voltage, and a fan efficiency speed band; and
fan historical data relating input power required to drive each said fan and associating the input power to a fan failure probability.

FIG. 1

Electronic Control System
(e.g., DSP)
12

Memory
(e.g. RAM/SRAM/DRAM/SDRAM/ROM/EEPROM, etc.)
14

| Fan Control/ Analysis/Wear-balancing Algorithms (including predictive learning algorithms) 16 | Fan Data and Specifications (e.g., HIGH/ LOW Fan efficiency band speeds; max current; nominal operating voltage, etc); look-up tables 18 | Fan Historical Data (e.g., cumulative run time of each fan, in-service date of each fan, etc.) look-up tables 20 |

Communications Interface Input/Out Subsystem 22

Fan Speed Sensing Subsystem (e.g., tachometer) 24

Fan current sensing and/or voltage measurement subsystem(s) 26

HMI subsystem (e.g., keypad/ display, etc.) 28

SNMP traps
Network

Fan feedback
Signals Fan feedback

DC PWM Fan
Drive SignalsDC PWM Fan

Fan Driver(s) Subsystem
30

EP 4 560 141 A1

**Fan Speed/Failure Probability Look-up Table**
(Assuming constant fan speed)

| Fan Input Power (in Watts) Fan Input Power | Fan Failure Probability (in %) |
|---|---|
| X1 | 5%-10% |
| X2 | 10%-20% |
| X3 | 15%-25% |
| X4 | 25%-45% |
| X5 | 45%-65% |
| X6 | 65%-85% |
| X7 | > 90% |

60

FIG. 3

50

Expected Fan speed (RPM) — Power(watts)

FIG. 2

**Goals**
- Keep each fan in the most efficient range
- Keep each fan in the most quiet range
- Evenly distribute operating hours across each fan
- sub goal if fan life cannot be balanced, then service alarms to "rotate the fans".

**Machine Learning Features:**
- run-time vs fan life time (alarm to "rotate fans")
- collect/store/analyze historical load profile to predict next fans speed (i.e., a given temp change, load, ambient temp, sensor temp, and location, adaptively set the needed fan speed).

Machine Learning Fan Commands:

The fan speed setting will use multi-variate linear regression to predict the correct fan speed based upon the current load, current temp, ambient temp, current delta temp, and fan location

The prediction model will continuously take the retrieved meter data and re-calculate the linear coefficients to "retrain" the model

Calculated Data:
-Temperature rate change for each sensor
- current load
- current temp for each sensor
- fan location
- fan speed
- using a best fit(least squares method), determine the learning linear coefficients such that,
$$Y = B0 + B1X1 + B2X2 + B3X3 + B4X4$$
Where:
Y: Fan speed setting
B1: Current Load
B2: Current Temp
B3: Ambient Temp
B4: Current Delta Temp

FIG. 4

Start Fans Off — 102

Retrieve Fan speeds, fan run-times, load of each device being cooled, And all temps — 104

Compare Fan run-times for all fans in sensor block

Are Fan runtimes on a sensor block balanced? — 106

Notify via alarm system to "Rotate Fan" blocks — 108

Calculate Data — 110

Is delta temp below threshold? — 112

Are run-times of fan block above min balancing threshold — 113

Is delta temp negative? — 114

Adjust fan ON/OFF of fan block to balance run-times — 113a

Command Fan/Block Faster based on machine learning — 132

Is fan speed below low efficiency watermark — 116

Command fan/block slower based on Machine Learning — 118

Are fans run-times balanced? — 120

Turn Fan off — 122

Are all fans on the same sensor block above high efficiency watermark — 124

Run all fans on sensor block at full speed — 126

Run fan at high efficiency watermark — 128

Is Fan speed above high efficiency watermark — 130

100

Europäisches
Patentamt
European
Patent Office
Office européen
des brevets

**Application Number**

EP 24 21 4235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 557 322 A (SUPER FUSION DIGITAL TECH CO LTD) 8 August 2023 (2023-08-08) | 1-11 | INV. F04D25/16 F04D27/00 F04D29/58 |
| A | * the whole document * * claims 1, 3, 5 * | 12-14 | |
| A | US 2013/345893 A1 (DAVID MILNES P [US] ET AL) 26 December 2013 (2013-12-26) * paragraphs [0095], [0110], [0113] - [0131] * * figure 12B * | 1-14 | |
| A | US 2011/066298 A1 (FRANCINO PETER N [US] ET AL) 17 March 2011 (2011-03-17) * paragraphs [0013], [0048], [0057], [0058] * | 1-14 | |
| A | JP 4 438533 B2 (DAIHEN CORP) 24 March 2010 (2010-03-24) * paragraphs [0011] - [0014] * | 1-14 | |
| | | | **TECHNICAL FIELDS SEARCHED (IPC)** F04D H01F H05K |

The present search report has been drawn up for all claims

| Place of search | Date of completion of the search | Examiner |
|---|---|---|
| The Hague | 6 March 2025 | De Tobel, David |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 21 4235

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2025

| Patent document cited in search report | | Publication date | Patent family member(s) | | Publication date |
|---|---|---|---|---|---|
| CN 116557322 | A | 08-08-2023 | NONE | | |
| US 2013345893 | A1 | 26-12-2013 | US 2013340996 A1 | | 26-12-2013 |
| | | | US 2013345893 A1 | | 26-12-2013 |
| US 2011066298 | A1 | 17-03-2011 | CA 2714466 A1 | | 11-03-2011 |
| | | | CN 102023623 A | | 20-04-2011 |
| | | | CN 104570743 A | | 29-04-2015 |
| | | | DE 102010037450 A1 | | 07-04-2011 |
| | | | GB 2473543 A | | 16-03-2011 |
| | | | GB 2551913 A | | 03-01-2018 |
| | | | PH 12010000273 A1 | | 05-09-2014 |
| | | | US 2011066298 A1 | | 17-03-2011 |
| JP 4438533 | B2 | 24-03-2010 | JP 4438533 B2 | | 24-03-2010 |
| | | | JP 2006019349 A | | 19-01-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63601696
- US 90659624